# EUROPÄISCHE PATENTANMELDUNG

(11) **EP 3 001 627 A1**
(43) Veröffentlichungstag der Anmeldung: **30.03.2016**
(21) Anmeldenummer: 15173840.8
(22) Anmeldetag: 25.06.2015
(51) Int. Cl.: H04L 25/49, H04L 7/00, H04L 5/18, H04L 25/02

(54) **VERFAHREN UND VORRICHTUNG ZUR SERIELLEN DATENÜBERTRAGUNG ÜBER EINEN BIDIREKTIONALEN DATENÜBERTRAGUNGSKANAL**

(30) Priorität: 26.09.2014 DE 102014219512
(71) Anmelder: Dr. Johannes Heidenhain GmbH, 83301 Traunreut (DE)
(72) Erfinder: SCHENZINGER, Daniel, 83349 Palling-Freutsmoos (DE); KREUZER, Stephan, 83362 Surberg-Ettendorf (DE); WALTER, Michael, 84570 Polling (DE); FLEISCHNMANN, Thomas, 83410 Laufen (DE); MOOSHAMMER, Markus, 83278 Traunstein (DE); BEAURY, Bernhard, 83236 Übersee (DE)

(57) **Zusammenfassung**

Die vorliegende Erfindung betrifft ein Verfahren zur seriellen Datenübertragung zwischen einer Positionsmesseinrichtung (10) und einer Folgeelektronik (100) über einen bidirektionalen Datenübertragungskanal (50), wobei die Datenübertragung entsprechend einem Datenübertragungscode codiert und in Form von Datenrahmen (200, 300) erfolgt und jeweils von einer senderseitigen Schnittstelleneinheit (40, 140) die Datenübertragung mit einer Startsequenz (210, 310) eingeleitet wird, deren Codierung von der Codierung des übrigen Datenrahmens (220, 230, 240; 330, 340) zumindest teilweise abweicht und jeweils von einer empfängerseitigen Schnittstelleneinheit (40, 140) der Beginn der Datenübertragung nach einer Umkehrung der Datenrichtung durch die Feststellung der Startsequenz (210, 310) erkannt wird. Weiter betrifft die Erfindung eine Vorrichtung geeignet zur Durchführung dieses Verfahrens.

## Beschreibung

### GEBIET DER TECHNIK

Die vorliegende Erfindung betrifft ein Verfahren zur seriellen Datenübertragung zwischen einer Positionsmesseinrichtung und einer Folgeelektronik über einen bidirektionalen Datenübertragungskanal nach Anspruch 1, sowie eine korrespondierende Vorrichtung nach Anspruch 10.

### STAND DER TECHNIK

Positionsmesseinrichtungen werden beispielsweise in der Automatisierungstechnik dafür eingesetzt, bei geregelten Antrieben Lageistwerte zu ermitteln, die eine Folgeelektronik, beispielsweise eine numerische Steuerung, benötigt, um Sollwerte für Regelkreise zu berechnen, mit denen der Antrieb (z.B. Vorschub eines Werkzeugs oder eines Werkstückes) kontrolliert wird. Handelt es sich bei den Positionsmesseinrichtungen um Drehgeber oder Winkelmessgeräte, so sind diese hierzu beispielsweise direkt oder indirekt mit der Welle eines Motors gekoppelt. Längenmessgeräte messen beispielsweise lineare Bewegungen zwischen einem Maschinenbett und einem relativ zum Maschinenbett positionierbaren Maschinenteil, beispielsweise einem verfahrbaren Werkzeugschlitten.

Heutzutage kommen vorzugsweise absolute Positionsmesseinrichtungen zum Einsatz. Diese erzeugen absolute Messwerte, die über digitale, meist serielle Datenschnittstellen von der Positionsmesseinrichtung zur Folgeelektronik übertragen werden. Bei den Messwerten handelt es sich meist um Positionswerte (Winkelwerte oder lineare Positionen), es sind aber auch Positionsmesseinrichtungen bekannt, die Geschwindigkeits- oder Beschleunigungswerte liefern, also Messwerte, die die zeitliche Änderung von Positionen angeben.

Ein nicht zu unterschätzender Kostenfaktor beim Anschluss von Positionsmesseinrichtungen an eine Folgeelektronik, beispielsweise eine Werkzeugmaschinensteuerung, ist die Anzahl der für den Betrieb benötigten elektrischen Leitungen, da diese maßgeblich den Preis der eingesetzten hochwertigen Datenkabel bestimmen. Aus diesem Grund geht man immer mehr dazu über, serielle Schnittstellen einzusetzen, bei denen die Datenübertragung über nur einen bidirektional betriebenen Datenübertragungskanal erfolgt. Eine derartige serielle Schnittstelle ist in der WO 2009/149966 A1 beschrieben. Um die teilweise großen Distanzen zwischen der Positionsmesseinrichtung und der Folgeelektronik überbrücken zu können, erfolgt die Signalübertragung über die Hauptübertragungsstrecke meist differentiell, beispielsweise nach dem bekannten RS-485-Standard. Für die Signalübertragung ist in diesem Fall ein einziges Leitungspaar erforderlich. Zum Senden und Empfangen von Daten sind in der Positionsmesseinrichtung und der Folgeelektronik jeweils geeignete Leitungstreiber und -empfänger vorgesehen.

Um die Datenrichtung umzukehren, deaktiviert das sendende Gerät seine Leitungstreiber, nachdem der zu sendende Datenrahmen vollständig ausgegeben wurde. Nachdem das empfangende Gerät den Datenrahmen vollständig empfangen hat, aktiviert dieses seine Leitungstreiber und wird damit zum sendenden Gerät, das wiederum einen Datenrahmen auf den Datenübertragungskanal ausgibt. In der Zeitspanne zwischen dem Deaktivieren der Leitungstreiber auf der einen Seite und dem Aktivieren der Leitungstreiber auf der anderen Seite, die maßgeblich durch die Laufzeit der Signale auf den Leitungen bestimmt wird, ist das Leitungspaar gegenüber den angeschlossenen Geräten hochohmig und daher anfällig für Störsignale. Damit nun das empfangende Gerät den Beginn einer Datenübertragung nach einer Umkehrung der Datenrichtung sicher erkennt, überträgt das sendende Gerät zu Beginn eines Datenrahmens stets einleitend eine Startsequenz (Präambel). Es hat sich jedoch gezeigt, dass Signalreflektionen unter ungünstigen Bedingungen Fehlerkennungen einer Startsequenz verursachen können.

Signalreflektionen treten auf, wenn die Datenübertragungsstrecke nicht optimal terminiert ist, d.h. wenn ein Abschlusswiderstand (Terminierungswiderstand) auf der Empfängerseite nicht optimal an eine Leitungsimpedanz des für den Datenübertragungskanal verwendeten Leitungspaars angepasst ist. In diesem Fall werden am Empfänger eintreffende Signale reflektiert und zum Sender zurückgeschickt. Findet nun eine Umkehrung der Datenrichtung statt, so wird der ursprüngliche Sender zum Empfänger der reflektierten Signale. Enthalten diese wiederum zufällig das Bitmuster der Startsequenz, so kann dies als Beginn einer Datenübertragung fehlgedeutet werden.

Dieses Problem kann umgangen werden, indem der Leitungsempfänger der empfangenden Einheit erst aktiviert wird, wenn aus einer Datenübertragung resultierende Signalreflektionen sicher abgeklungen sind. Dies resultiert aber in einer unerwünschten Verlängerung der Zugriffszyklen und soll damit vermieden werden.

### ZUSAMMENFASSUNG DER ERFINDUNG

Es ist Aufgabe der vorliegenden Erfindung, ein Verfahren zur Datenübertragung zwischen einer Positionsmesseinrichtung und einer Folgeelektronik zu schaffen, mit dem der Beginn einer Datenübertragung zuverlässig erkannt werden kann.

Diese Aufgabe wird gelöst durch ein Verfahren nach Anspruch 1.

Es wird ein Verfahren zur seriellen Datenübertragung zwischen einer Positionsmesseinrichtung und einer Folgeelektronik über einen bidirektionalen Datenübertragungskanal vorgeschlagen, bei dem die Datenübertragung entsprechend einem Datenübertragungscode codiert und in Form von Datenrahmen erfolgt und jeweils von einer senderseitigen Schnittstelleneinheit die Datenübertragung mit einer Startsequenz eingeleitet wird, deren Codierung von der Codierung des übrigen Datenrahmens zumindest teilweise abweicht und jeweils von einer empfängerseitigen Schnittstelleneinheit der Beginn der Datenübertragung nach einer Umkehrung der Datenrichtung durch die Feststellung der Startsequenz erkannt wird.

Weiter ist es Aufgabe der vorliegenden Erfindung, eine Vorrichtung zur Datenübertragung zwischen einer Positionsmesseinrichtung und einer Folgeelektronik zu schaffen, mit der der Beginn einer Datenübertragung zuverlässig erkennbar ist.

Diese Aufgabe wird gelöst durch eine Vorrichtung nach Anspruch 10.

Hier wird eine Vorrichtung zur seriellen Datenübertragung zwischen einer Positionsmesseinrichtung und einer Folgeelektronik über einen bidirektionalen Datenübertragungskanal vorgeschlagen, bei der sowohl in der Positionsmesseinrichtung, als auch in der Folgeelektronik je eine Schnittstelleneinheit vorgesehen ist, in der aus zu sendenden Daten und/oder Befehlen, die ihr von Quellkomponenten zuführbar sind, Datenrahmen erzeugbar, entsprechend einem Datenübertragungscode codierbar und an den Datenübertragungskanal ausgebbar sind, und wobei jeweils senderseitig die Datenübertragung mit einer Startsequenz einleitbar ist, deren Codierung von der Codierung des übrigen Datenrahmens zumindest teilweise abweicht und jeweils empfängerseitig in der Schnittstelleneinheit der Beginn der Datenübertragung nach einer Umkehrung der Datenrichtung durch die Feststellung der Startsequenz erkennbar ist.

Weitere Vorteile und Details eines erfindungsgemäßen Verfahrens, sowie einer korrespondierenden Vorrichtung ergeben sich aus der Beschreibung der nachfolgenden Ausführungsbeispiele.

### KURZE BESCHREIBUNG DER ZEICHNUNGEN

Es zeigt
- Figur 1: ein Blockdiagramm einer Positionsmesseinrichtung und einer Folgeelektronik, die über einen bidirektionalen Datenübertragungskanal miteinander verbunden sind,
- Figur 2: ein Signaldiagramm zur Erläuterung einer Manchester-Codierung,
- Figur 3: ein Signaldiagramm eines erfindungsgemäßen Kommunikationszyklus',
- Figur 4: ein Blockdiagramm einer Schnittstelleneinheit der Positionsmesseinrichtung und
- Figur 5: ein Blockdiagramm einer Schnittstelleneinheit der Folgeelektronik.

### BESCHREIBUNG DER AUSFÜHRUNGSFORMEN

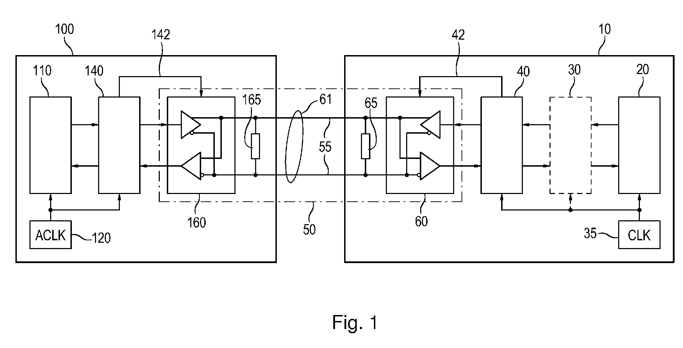

Figur 1 zeigt ein Blockdiagramm einer Positionsmesseinrichtung 10 und einer Folgeelektronik 100, die über einen bidirektionalen Datenübertragungskanal 50 miteinander verbunden sind.

Die Positionsmesseinrichtung 10 weist Messgerätekomponenten in Form einer Positionserfassungseinheit 20 und einer optionalen Verarbeitungseinheit 30 auf. Die Positionserfassungseinheit 20 ist geeignet ausgestaltet, um digitale Positionswerte zu erzeugen. Sie umfasst hierzu beispielsweise eine Maßverkörperung mit einer Messteilung, eine Abtasteinheit für deren Abtastung, sowie eine Signalverarbeitungselektronik zur Bildung des digitalen Positionswerts aus Abtastsignalen der Abtasteinheit, die durch die Abtastung der Messteilung generiert werden. Maßverkörperung und Abtasteinheit sind in bekannter Weise relativ zueinander beweglich angeordnet und mechanisch mit Maschinenteilen verbunden, deren Position zueinander gemessen werden soll. Handelt es sich bei der Positionsmesseinrichtung 10 um einen Drehgeber, mit dem die Winkelposition der Welle eines Elektromotors gemessen werden soll, so ist die Abtasteinheit (bzw. das Gehäuse des Drehgebers) beispielsweise an einem Motorgehäuse angebracht und eine Welle des Drehgebers, die mit der Maßverkörperung drehfest verbunden ist, ist über eine Wellenkupplung mit der zu messenden Motorwelle verbunden.

Insbesondere um für die digitalen Schaltungsteile eine Zeitbasis, bzw. ein definiertes Zeitraster zur Verfügung zu stellen, ist in der Positionsmesseinrichtung 10 weiter ein Taktgenerator 35 angeordnet. Er liefert ein Arbeitstaktsignal CLK, das digitalen Zustandsautomaten, Mikroprozessoren, Mikrokontrollern etc. zugeführt ist.

Das physikalische Abtastprinzip, das der Positionserfassungseinheit 20 zugrunde liegt, ist für die vorliegende Erfindung bedeutungslos. So kann es sich um ein optisches, magnetisches, kapazitives oder induktives Abtastprinzip handeln. Entsprechend den notwendigen Verarbeitungsschritten, die erforderlich sind, um die Abtastsignale der Abtasteinheit zu Positionswerten zu verarbeiten, umfasst die Signalverarbeitungselektronik Funktionseinheiten, die Verarbeitungsschritte wie Verstärkung, Signalkorrektur (Offset-, Amplituden-, Phasenkorrektur), Interpolation, Zählung von Teilungsperioden, A/D-Wandlung,... ausführen. Für die Übertragung von Steuersignalen und/oder Daten zwischen der Positionserfassungseinheit 20 und der Verarbeitungseinheit 30 sind geeignete Signalleitungen vorgesehen. Sie dienen insbesondere dazu, die in der Positionserfassungseinheit 20 generierten Positionswerte zur Verarbeitungseinheit 30 zu übertragen.

In der Verarbeitungseinheit 30 werden die Positionswerte ggf. weiter verarbeitet um Ausgabedaten zu erhalten. Hierzu können Verarbeitungsschritte wie Skalierung, Änderung des Datenformats, Fehlerkorrektur, etc. erforderlich sein, die in der Verarbeitungseinheit 30 rein digital ausgeführt werden. Ausgabedaten können aber nicht nur Positionswerte, sondern auch Geschwindigkeits- oder Beschleunigungswerte sein, die in der Verarbeitungseinheit 30 aus mehreren, hintereinander erzeugten Positionswerten berechnet werden.

Zur Kommunikation mit der Folgeelektronik 100 einerseits und den Messgerätekomponenten 20, 30 andererseits ist in der Positionsmesseinrichtung 10 weiter eine Schnittstelleneinheit 40 angeordnet. Insbesondere erfolgt über die Schnittstelleneinheit 40 die Übertragung der Ausgabedaten zur Folgeelektronik 100. Die Ausgabedaten werden der Schnittstelleneinheit 40 über geeignete Signalleitungen von der Verarbeitungseinheit 30 oder der Positionserfassungseinheit 20 übermittelt. Auch der Schnittstelleneinheit 40 ist das Arbeitstaktsignal CLK zugeführt.

Die physikalische Verbindung zur Übertragung von Befehlen und Daten zwischen der Schnittstelleneinheit 40 der Positionsmesseinrichtung 10 und einer korrespondierenden Schnittstelleneinheit 140 der Folgeelektronik 100 wird über den bidirektionalen Datenübertragungskanal 50 hergestellt. Hierzu sind dem Datenübertragungskanal 50 in der Positionsmesseinrichtung 10 eine Sende-/Empfängereinheit 60 und in der Folgeelektronik 100 eine korrespondierende Sende-/Empfängereinheit 160 zugeordnet, die wiederum über ein Schnittstellenkabel 61 miteinander verbunden sind. Die Sende-/Empfängereinheiten 60, 160 im vorliegenden Ausführungsbeispiel sind geeignet ausgestaltet um die jeweils zu sendenden Befehle und/oder Daten, die üblicherweise als massebezogene (single-ended) Signale vorliegen, in differentielle Signale, beispielsweise entsprechend dem weit verbreiteten RS-485-Standard, umzuwandeln und aus eintreffenden differentiellen Signalen massebezogene Signale zu generieren. Für die Signalübertragung zwischen den Sende-/Empfängereinheiten 60, 160 ist im Schnittstellenkabel 61 ein Leitungspaar 55 vorgesehen. Die beiden Leitungen des Leitungspaares 55 sind üblicherweise miteinander verdrillt, so dass Störeinflüsse, beispielsweise elektromagnetische Störfelder, die Signale beider Leitungen gleichermaßen stören. Da für die Auswertung lediglich die Differenz der Signale ausschlaggebend ist, ist diese Art der Signalführung sehr störunempfindlich.

Alternativ zur drahtgebundenen Signalübertragung kann auch eine optische Übertragung (via Glasfaserkabel) oder eine drahtlose Übertragung mittels einer Funkschnittstelle vorgesehen werden.

Die Datenrichtung der Sende-/Empfängereinheiten 60, 160 ist von den ihnen zugeordneten Schnittstelleneinheiten 40, 140 über ein Umschaltsignal 42, 142 einstellbar, mit dem die Sende-/Empfängereinheiten 60, 160 aktivierbar bzw. deaktivierbar sind. Bei einer Umkehrung der Datenrichtung deaktiviert die senderseitige Schnittstelleneinheit 40, 140 die Leitungstreiber ihrer Sende-/Empfängereinheit 60, 160, nachdem die Übertragung (Ausgabe eines Datenrahmens) beendet ist und die empfängerseitige Schnittstelleneinheit 40, 140 aktiviert die Leitungstreiber ihrer Sende-/Empfängereinheit 60, 160, sobald der eintreffende Datenrahmen vollständig empfangen wurde und wird dadurch sendebereit.

Jeweils an den Eingängen der Sende-/Empfängereinheiten 60, 160 sind Leitungs-Terminierungen 65, 165 vorgesehen. Sie dienen insbesondere während der Umkehrung der Datenrichtung dazu, Signalreflexionen zu verhindern, die auf der Empfängerseite auftreten. Signalreflexionen kommen dann zustande, wenn die Eingangsimpedanz des Empfängers (der Sende-/Empfängereinheit 60, 160) nicht an die Leitungsimpedanz des für die Signalübertragung verwendeten Leitungspaares 55 angepasst ist. In der Praxis werden als Leitungs-Terminierungen 65, 165 meist einfache ohmsche Widerstände eingesetzt, deren Wert der Impedanz des Leitungspaares 55 entspricht. Wenn also die Impedanz des verdrillten Leitungspaares 55 beispielsweise 120 Ohm beträgt, so werden an beiden Enden des Schnittstellenkabels 61, also jeweils am Eingang der Sende-/Empfängereinheit 60, 160 die beiden Leitungen mittels eines Widerstands mit 120 Ohm überbrückt. Es sind aber auch komplexere Leitungs-Terminierungen 65, 165 bekannt, die neben passiven Bauteilen (z.B. Widerständen) auch aktive Bauteile enthalten können.

Da die Leitungsimpedanz von vielen Faktoren abhängig ist, können Signalreflexionen durch Leitungs-Terminierungen 65, 165 nicht vollkommen verhindert, sondern lediglich verringert (gedämpft) werden. Insbesondere bei bidirektional betriebenen Datenübertragungskanälen 50, bei denen durch Umkehrung der Datenrichtung Signale in beiden Richtungen übertragen werden, gilt es deshalb zu verhindern, dass Signalreflexionen fälschlicherweise als reguläre Datenübertragung erkannt werden.

Die Art und Weise, wie die Kommunikation zwischen Folgeelektronik 100 und Positionsmesseinrichtung 10 erfolgt, ist in einem Schnittstellenprotokoll festgelegt. Häufig kommt dabei ein sog. Frage-Antwort-Schema zum Einsatz, d.h. in einem Kommunikationszyklus sendet die Folgeelektronik 100 (Master) einen Befehl, ggf. gefolgt von Daten, zur Positionsmesseinrichtung 10 (Slave), diese bearbeitet den Befehl und sendet ggf. angeforderte Daten zur Folgeelektronik 100. Befehle können allgemein Schreib- und/oder Lesebefehle sein, beispielsweise zum Beschreiben oder Auslesen von Speicherzellen in der Verarbeitungseinheit 30. Für die Anforderung eines Positionswerts als Ausgangsdatum zur Folgeelektronik 100 kann ein spezieller Positionsanforderungsbefehl vorgesehen sein.

Wie alle Abläufe in der Folgeelektronik 100 werden auch Zugriffe auf die Positionsmesseinrichtung 10 von einer internen Steuereinheit 110 gesteuert. Handelt es sich bei der Folgeelektronik 100 um eine Numerische Steuerung oder ein sonstiges Steuergerät der Automatisierungstechnik, so fordert die Steuereinheit 110 über die Schnittstelleneinheit 140 beispielsweise kontinuierlich Positionswerte von der Positionsmesseinrichtung 10 an, um Positionsistwerte (Lageistwerte) zu erhalten, die sie für Regelkreise benötigt, etwa um mechanische Komponenten einer Maschine über einen Antrieb präzise zu positionieren (Servoantrieb).

Auch in der Folgeelektronik 100 ist ein Taktgenerator 120 angeordnet, der ein Arbeitstaktsignal ACLK generiert, das zur Bildung einer Zeitbasis, bzw. eines Zeitrasters der Steuereinheit 110 und der Schnittstelleneinheit 140 zugeführt ist.

Befehle und Daten werden von den Schnittstelleneinheiten 40, 140 in Form von Datenrahmen übertragen, die entsprechend den Definitionen des Datenübertragungsprotokolls aufgebaut sind. Im Folgenden sind einige typische Komponenten von Datenrahmen aufgelistet:

### Startsequenz (Preamble)

Die Startsequenz leitet die Übertragung eines Datenrahmens ein und dient dazu, der jeweils empfangenden Einheit zu signalisieren, dass Befehle und/oder Daten zu erwarten sind. Erfindungsgemäß ist die Startsequenz so ausgeführt, dass sie, auch bei Auftreten von Signalreflektionen, eindeutig identifizierbar ist.

### Befehl

Befehle werden normalerweise nur vom Master (Folgeelektronik 100) zum Slave (Positionsmesseinrichtung 10) geschickt und signalisieren die Art des Zugriffs, z.B. Schreib- oder Lesezugriff. Befehle können eine definierte Länge haben, beispielsweise 8 Bit.

### Empfangsdaten

Empfangsdaten sind Daten, die vom Master (Folgeelektronik 100) zum Slave (Positionsmesseinrichtung 10) gesendet werden. Sie können u.a. auch Adressen umfassen, die bei einem Lesebefehl bestimmen, von welcher Speicheradresse Daten gelesen werden sollen, bzw. bei einem Schreibbefehl die Zieladresse von zu schreibenden Daten angeben.

### Sendedaten

Sendedaten sind (vom Master (Folgeelektronik 100) per Befehl angeforderte) Daten, die vom Slave (Positionsmesseinrichtung 10) zum Master (Folgeelektronik 100) übertragen werden. Insbesondere sind Sendedaten auch die in der Positionsmesseinrichtung 10 ermittelten Messwerte, z.B. Positionswerte.

### Endsequenz (Postamble)

Die Endsequenz schließt die Übertragung des Datenrahmens ab. Sie kann aus nur einem Bit (Stoppbit) oder einer definierten Bitfolge bestehen.

Die Empfangs- und/oder Sendedaten, sowie ggf. die Endsequenz können zusätzlich noch Prüfsummen (CRC) enthalten, um empfängerseitig eine Erkennung von Übertragungsfehlern zu ermöglichen.

Erfindungsgemäß werden die Datenrahmen nicht uncodiert (also der Wert jedes zu übertragenden Bits mittels seines zugeordneten Signalpegels über eine definierte Signaldauer), sondern codiert übertragen. Zu diesem Zweck werden senderseitig auf den zu übertragenden Datenrahmen Codierungsregeln angewandt, bevor er in Form eines Datenstroms über den Datenübertragungskanal 50 übertragen wird. Analog hierzu werden empfängerseitig auf den eintreffenden Datenstrom Decodierungsregeln angewandt, um wieder den originalen Datenrahmen zu erhalten.

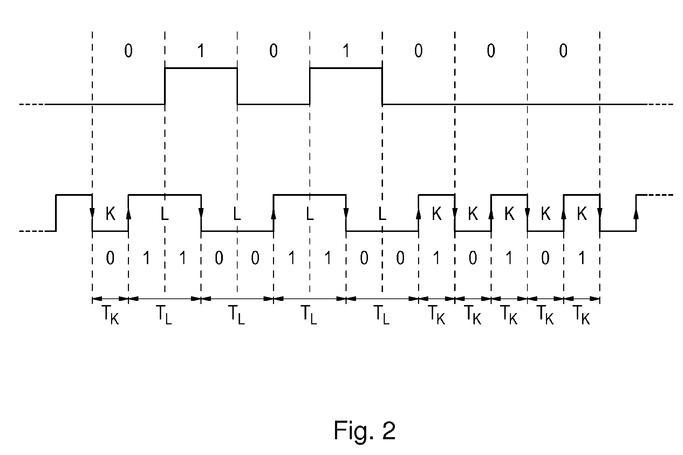

Besonders vorteilhafte Codierungen sind verschiedene Varianten der Manchester-Codierung, bei der die zu übertragenden Bits in Form von Signalflanken codiert werden. Bei der in Figur 2 dargestellten Manchester-Codierung wird beispielsweise eine logische "0" durch eine steigende Signalflanke ersetzt und eine logische "1" durch eine fallende Signalflanke. Dadurch wird aus der oben dargestellten zu übertragenden Bitfolge "0101000" die codierte Bitfolge "01100110010101". Dies hat zum einen den Vorteil, dass durch den zwingend auftretenden Pegelwechsel je zu übertragendem Bit eine Überprüfung der Datenübertragung ermöglicht wird, zum anderen ist die codierte Bitfolge gleichanteilsfrei, was es ermöglicht, durch Modulationsverfahren die codierte Bitfolge und eine Versorgungsspannung über das gleiche Leitungspaar 55 zu übertragen.

Durch die Manchester-Codierung ergibt sich für den codierten Datenstrom eine Abfolge von kurzen Symbolen K mit einer Zeitdauer T_{K} und langen Symbolen L mit einer Zeitdauer T_{L}. Für die Überprüfung der Datenübertragung kann beispielsweise die Tatsache genutzt werden, dass bei regulärer Codierung kurze Symbole K immer paarweise auftreten, bzw. eine gerade Anzahl von kurzen Symbolen K auftritt. Das Auftreten eines einzelnen kurzen Symbols K oder einer ungeraden Anzahl von aufeinanderfolgenden kurzen Symbolen K bedeutet somit eine Abweichung von der Codierung des übrigen Datenrahmens.

Neben der in Figur 2 dargestellten Variante der Manchester-Codierung ist selbstverständlich auch eine umgekehrte Zuordnung der Signalflanken zu den logischen Pegeln möglich. Ebenso geeignet ist die differentielle Manchestercodierung.

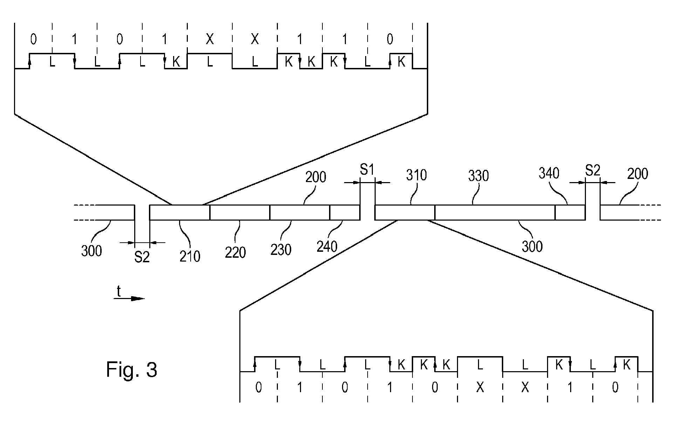

Figur 3 zeigt beispielhaft einen erfindungsgemäßen Kommunikationszyklus zwischen einer Folgeelektronik 100 und einer Positionsmesseinrichtung 10. Dabei überträgt zuerst die Folgeelektronik 100 einen ersten Datenrahmen 200 zur Positionsmesseinrichtung 10, anschließend wird die Datenrichtung des Datenübertragungskanals 50 im Zeitfenster S1 umgeschaltet und die Positionsmesseinrichtung 10 überträgt einen zweiten Datenrahmen 300 als Reaktion auf den ersten Datenrahmen 200 zur Folgeelektronik 100. Die Folgeelektronik 100 fungiert in diesem Beispiel somit als Master, der Daten anfordert und die Positionsmesseinrichtung 10 als Slave, der Daten als Reaktion auf die Anforderung vom Master sendet. Die Übertragung der Datenrahmen 200, 300 erfolgt manchester-codiert.

Das Zeitfenster S1 wird zu einem wesentlichen Teil durch die Laufzeit der Signale über den Datenübertragungskanal 50, insbesondere der Kabel-Laufzeit über das Schnittstellenkabel 61, bestimmt. Das liegt darin begründet, dass zwar die Sende-/Empfängereinheit 160 der Folgeelektronik 100 unmittelbar nach dem Senden des ersten Datenrahmens 200 von Sende- auf Empfängerbetrieb umschalten kann, die Umschaltung der Sende-/Empfängereinheit 60 der Positionsmesseinrichtung 10 aber erst erfolgen kann, nachdem der (um die Kabel-Laufzeit verzögerte) erste Datenrahmen 200 vollständig empfangen wurde.

Der erste Datenrahmen 200 wird mit einer Startsequenz 210 eingeleitet, auf die ein Befehl 220 folgt. Optional können dann (aus der Sicht der Positionsmesseinrichtung 10 betrachtet) Empfangsdaten 220 übertragen werden, bevor der erste Datenrahmen 200 mit einer Endsequenz 240 abgeschlossen wird. Bei dem Befehl 220 kann es sich beispielsweise um einen Positionsanforderungsbefehl handeln, der die Positionsmesseinrichtung 10 dazu auffordert, einen Positionswert zu generieren und zur Folgeelektronik 100 zu übertragen.

Der zweite Datenrahmen 300 wird ebenfalls mit einer Startsequenz 310 eingeleitet. Da die Positionsmesseinrichtung 10 als Slave arbeitet, umfasst der zweite Datenrahmen 300 lediglich Sendedaten 330 aber keinen Befehl. Abgeschlossen wird der zweite Datenrahmen 300 wieder mit einer Endsequenz 340. Die Sendedaten 330 können beispielsweise den auf den Positionsanforderungsbefehl generierten Positionswert, sowie Zusatzdaten umfassen. Zusatzdaten sind beispielsweise Daten, die durch Auswertung zusätzlicher in der Positionsmesseinrichtung 10 enthaltener Sensoren (z.B. Temperatursensoren) gewonnen werden, es kann sich aber auch um Statusinformationen oder beliebige Speicherinhalte handeln.

Nach der Übertragung der Endsequenz 340 wird in einem weiteren Zeitfenster S2 die Datenrichtung wieder umgeschaltet, so dass die Folgeelektronik 100 wieder einen ersten Datenrahmen 200 senden kann. Insbesondere dann, wenn die Positionswerte der Positionsmesseinrichtung 10 als Positionsistwerte für einen Servoantrieb o.ä. benötigt werden, folgen, wie in Figur 3 angedeutet, Kommunikationszyklen in kurzen Zeitabständen hintereinander. Die eingangs erörterte Gefahr der Fehlerkennung von Startsequenzen besteht somit nicht nur zwischen dem Ende des ersten Datenrahmens 200 und dem Anfang des zweiten Datenrahmens 300, sondern auch zwischen dem Ende des zweiten Datenrahmens 300 und dem Anfang des ersten Datenrahmens 200 (des darauffolgenden Kommunikationszyklus).

Erfindungsgemäß sind die Startsequenzen 210, 310 der Datenrahmen 200, 300 so aufgebaut, dass ihre Codierung zumindest teilweise von der Codierung der übrigen Blöcke der Datenrahmen 200, 300 (Befehl 220, Empfangsdaten 230, Endsequenz 240, bzw. Sendedaten 330, Endsequenz 340) abweicht. Dadurch, dass durch Signalreflektionen hervorgerufene Datenströme die der Signalübertragung zugrunde liegende Manchester-Codierung aufweisen, sind nun die Startsequenzen 210, 310 eben durch die von der Manchester-Codierung abweichenden Codierung eindeutig erkennbar.

In diesem Beispiel besteht die Abweichung von der Codierung darin, dass in Bereichen X entgegen den Codierungsregeln der Manchester-Codierung keine Signalflanken auftreten. Den Bereichen X kann somit weder eine logische "0", noch eine logische "1" zugeordnet werden. Besonders vorteilhaft ist es, wenn, wie in Figur 3 dargestellt, zwischen zwei Bereichen X eine Signalflanke auftritt, da in diesem Fall trotz abweichender Codierung das Frequenzspektrum der Übertragung nicht beeinflusst wird.

Da in einem manchester-codierten Datenstrom immer eine gerade Anzahl von aufeinanderfolgenden kurzen Symbolen K vorliegt, die vorliegende Abweichung von der Codierung aber zu einzeln auftretenden kurzen Symbolen K und/oder einer ungeraden Anzahl von aufeinanderfolgenden kurzen Symbolen K führt, ist diese Art der Abweichung von der Codierung bei der Auswertung des Datenstroms besonders einfach zu erkennen.

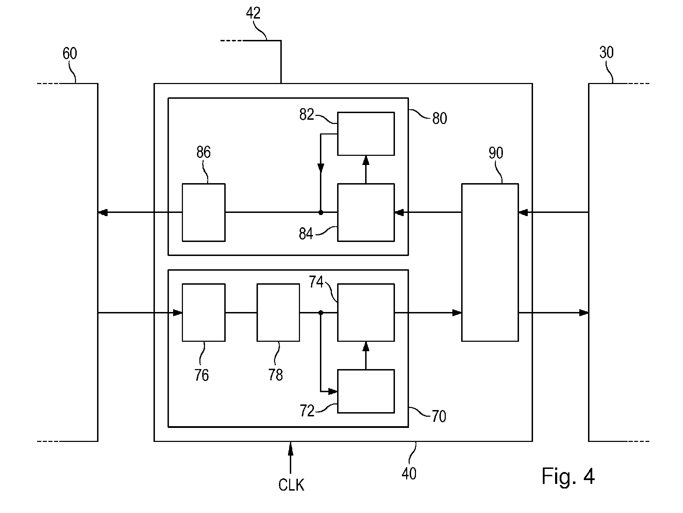

Figur 4 zeigt ein Blockdiagram einer erfindungsgemäßen Schnittstelleneinheit 40 der Positionsmesseinrichtung 10. Sie umfasst eine Leseeinheit 70, eine Ausgabeeinheit 80, sowie eine Kommunikationseinheit 90.

Die Leseeinheit 70 dient zum Einlesen und Verarbeiten von eintreffenden Datenströmen. Sie umfasst hierzu eine Vergleichereinheit 72, der der eintreffende Datenstrom zugeführt ist. Diese vergleicht den Inhalt des Datenstroms mit einer gültigen Startsequenz und signalisiert bei positivem Vergleichsergebnis, also wenn eine gültige Startsequenz 210 und somit das Eintreffen eines ersten Datenrahmens 200 erkannt wurde, einer Decodierungseinheit 74, dass nun ein erster Datenrahmen 200 zu verarbeiten ist. Die Decodierungseinheit 74 decodiert den verbleibenden Teil-Datenrahmen (Befehl 220, Empfangsdaten 230, Endsequenz 240) und gibt dessen Inhalt (Befehl 220 und ggf. Empfangsdaten 230) in decodierter Form an die Kommunikationseinheit 90 aus.

Abhängig von der Codierung und der physikalischen Übertragung des ersten Datenrahmens 200 kann vor der Auswertung des Datenstroms in der Vergleichereinheit 72 und der Decodierungseinheit 74 eine Vorverarbeitung notwendig sein. Im vorliegenden Fall, wo dem eintreffenden Datenstrom und der Messgeräteelektronik verschiedene Zeitraster zugrunde liegen, wird der Datenstrom erst in einer Synchronisationseinheit 76 mit dem Arbeitstaktsignal CLK der Positionsmesseinrichtung 10 synchronisiert. Der resultierende synchrone Datenstrom ist einem Symbolentscheider 78 zugeführt, der die Abfolge von kurzen Symbolen K und langen Symbolen L im synchronen Datenstrom ermittelt und lediglich diese Information an die Decodierungseinheit 74 zur Decodierung weiterleitet. Der Inhalt des über den Datenübertragungskanal (50) eintreffenden Datenstroms ändert sich durch die Vorverarbeitung nicht.

Die Kommunikationseinheit 90 gibt Befehle 220 und ggf. Empfangsdaten 230 an die jeweils adressierte(n) Zielkomponente(n) (z.B. Positionserfassungseinheit 20, Verarbeitungseinheit 30,...) weiter. Darüber hinaus empfängt die Kommunikationseinheit 90, beispielsweise von der Positionserfassungseinheit 20 oder der Verarbeitungseinheit 30, Sendedaten 330, bildet wiederum einen Teil-Datenrahmen (der in diesem Fall die Sendedaten 330 und eine Endsequenz 340 umfasst) und gibt ihn an eine Ausgabeeinheit 80 der Schnittstelleneinheit 40 aus. In dieser Datenrichtung fungieren die Verarbeitungseinheit 30 und/oder die Positionserfassungseinheit 20 als Quellkomponenten für die Datenübertragung.

In der Ausgabeeinheit 80 wird der Teil-Datenrahmen 330, 340 in einer Codierungseinheit 84 codiert. Zur Ausgabe des Datenrahmens 300 wird erst von einer Startsequenz-Ausgabeeinheit 82 die noch fehlende erfindungsgemäße Startsequenz 310 und anschließend von der Codierungseinheit 84 der Teil-Datenrahmen mit den Sendedaten 330 und der Endsequenz 340 ausgegeben.

Auch in der Ausgabeeinheit 80 kann, abhängig von der gewählten Codierung oder der Art der physikalischen Datenübertragung, eine Weiterverarbeitung des von der Startsequenz-Ausgabeeinheit 82 und der Codierungseinheit 84 ausgegebenen, den zweiten Datenrahmen 300 repräsentierenden Datenstroms vorgenommen werden. So kann beispielsweise die Datenübertragungsrate des Datenstroms, der im vorliegenden Beispiel als Abfolge von kurzen Symbolen K und langen Symbolen L vorliegt, in einer Übertragungseinheit 86 eingestellt werden, bevor er über den bidirektionalen Datenübertragungskanal 50 an die Folgeelektronik 100 ausgegeben wird.

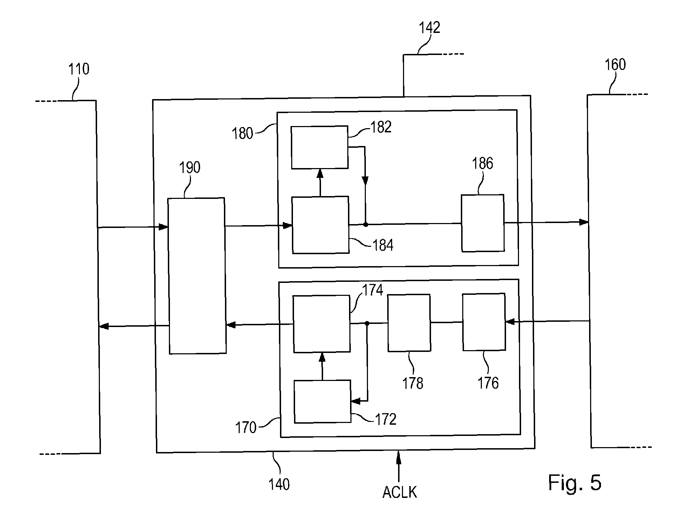

Figur 5 zeigt, als Gegenstück zur erfindungsgemäßen Schnittstelleneinheit 40 der Positionsmesseinrichtung 10, ein Blockdiagramm einer entsprechenden Schnittstelleneinheit 140 der Folgeelektronik 100.

Die Schnittstelleneinheiten 40, 140 sind symmetrisch zueinander aufgebaut, daher findet jede Einheit der Schnittstelleneinheit 40 seine Entsprechung in der Schnittstelleneinheit 140. So weist auch die Schnittstelleneinheit 140 eine Leseeinheit 170 mit einer Vergleichereinheit 172, einer Decodierungseinheit 174 auf. Darüber hinaus kann, je nach gewählter Codierung, auch eine Synchronisationseinheit 176 und ein Symbolentscheider 178 vorgesehen sein. Ebenso ist eine Ausgabeeinheit 180 mit einer Startsequenz-Ausgabeeinheit 182, einer Codierungseinheit 184 und einer Übertragungseinheit 186 vorhanden. Lediglich die Kommunikationseinheit 190 unterscheidet sich dahingehend von der Kommunikationseinheit 90, dass sie auch Befehle 220 der Steuereinheit 110 in erste Datenrahmen 200 integrieren muss, während zweite Datenrahmen 300, die von der Positionsmesseinrichtung 100 eintreffen, keine zu verarbeitenden Befehle enthalten. Dies liegt darin begründet, dass es sich bei dem vorliegenden Ausführungsbeispiel um ein Master-Slave-System handelt, dass also nur der Master (die Folgeelektronik 100) Kommunikationszyklen initiiert und der Slave (die Positionsmesseinrichtung 10) lediglich eintreffende Befehle abarbeitet.

Es sind jedoch auch Vorrichtungen zur Datenübertragung bekannt, bei denen jeder Teilnehmer Befehle sowohl senden, als auch empfangen und bearbeiten kann. Bei einer derartigen Vorrichtung können die beiden Kommunikationseinheiten 40, 140 vollständig identisch ausgeführt sein.

Die Steuereinheit 110 fungiert auf der Seite der Folgeelektronik 100 je nach Datenrichtung als Quellkomponente oder als Zielkomponente.

Ebenfalls sind Vorrichtungen zur Datenübertragung bekannt, bei denen mehr als zwei Teilnehmer über einen Datenübertragungskanal 50 kommunizieren.

Um unterscheiden zu können, von welchem Teilnehmer 10, 100 ein Datenrahmen 200, 300 stammt, ist es generell von Vorteil, wenn die Datenrahmen 200, 300 voneinander unterscheidbare Startsequenzen 210, 310 aufweisen, insbesondere durch verschiedene Abweichungen von der Codierung des übrigen Datenrahmens 200, 300.

Neben der beschriebenen Manchester-Codierung sind im Rahmen der vorliegenden Erfindung auch andere Bitcodierungen wie z.B. MLT-3-Code oder RZ-Code ("Return to Zero") einsetzbar. Unter dem Begriff Bitcodierung sind Codes zu verstehen, bei denen jedes zu übertragende Bit für sich codiert und übertragen wird. So wird bei der Manchester-Codierung jedes Bit als steigende oder fallende Signalflanke übertragen, d.h. die Übertragung erfolgt als 0-1-Folge oder 1-0-Folge. Bei der MLT-3-Codierung wird die Übertragung einer logischen "0" durch gleichbleibenden Signalpegel, die Übertragung einer logischen "1" durch die Veränderung des Signalpegels codiert. Beim RZ-Code werden die Bits durch einen positiven oder negativen Spannungspuls übertragen, wobei die Spannung zwischen zwei Bits stets auf einen neutralen Spannungswert ("Zero") zurückkehrt.

Darüber hinaus können auch Bitgruppencodierungen eingesetzt werden, also Codes, bei denen jeweils eine Gruppe von n Bits (n>1) gegen eine Gruppe mit m Bits ausgetauscht wird, wobei m>n ist. Bitgruppencodierungen werden üblicherweise eingesetzt, um eine weitgehend gleichanteilsfreie Übertragung von Datenströmen zu erreichen. Außerdem können bei einer Bitgruppencodierung gezielt Bitwechsel erzwungen werden, was eine empfängerseitige Taktrückgewinnung begünstigt. Typisches Beispiel hierfür ist die 4b5b-Codierung, bei der Gruppen von 4 Bits gegen Gruppen von 5 Bits ersetzt werden. Bitgruppen, die nicht zur Codierung des übrigen Datenrahmens (also dem in der Kommunikationseinheit 90, 190 gebildeten Teil-Datenrahmen, umfassend den ersten Datenrahmen 200 oder den zweiten Datenrahmen 300 jeweils ohne Startsequenz 210, 310) benötigt werden, können hier für die Startsequenz 210, 310 genutzt werden. Dabei muss gewährleistet sein, dass in der Startsequenz 210, 310 wenigstens eine Gruppe vorhanden ist, die im übrigen Datenrahmen, auch im Übergangsbereich zwischen zwei Gruppen, nicht vorkommen kann.

Schließlich ist auch eine Kombination aus Bitcodierung und Bitgruppencodierung möglich, beispielsweise indem ein Datenrahmen erst bitgruppencodiert (4b5b) und dann bitcodiert (MLT-3) wird. Wichtig ist in jedem Fall, dass die Codierung der Startsequenz 210, 310 von der Codierung des übrigen Datenrahmens abweicht.

## Patentansprüche

1. Verfahren zur seriellen Datenübertragung zwischen einer Positionsmesseinrichtung (10) und einer Folgeelektronik (100) über einen bidirektionalen Datenübertragungskanal (50), wobei die Datenübertragung entsprechend einem Datenübertragungscode codiert und in Form von Datenrahmen (200, 300) erfolgt und jeweils von einer senderseitigen Schnittstelleneinheit (40, 140) die Datenübertragung mit einer Startsequenz (210, 310) eingeleitet wird, deren Codierung von der Codierung des übrigen Datenrahmens (220, 230, 240; 330, 340) zumindest teilweise abweicht und jeweils von einer empfängerseitigen Schnittstelleneinheit (40, 140) der Beginn der Datenübertragung nach einer Umkehrung der Datenrichtung durch die Feststellung der Startsequenz (210, 310) erkannt wird.

2. Verfahren nach Anspruch 1, wobei die Schnittstelleneinheit (40, 140) eine Kommunikationseinheit (90, 190), eine Ausgabeeinheit (80, 180) und eine Leseeinheit (70, 170) umfasst und wobei in der Kommunikationseinheit (90, 190)
• aus zu sendenden Daten und/oder Befehlen, die ihr von Quellkomponenten (20, 30, 110) zugeführt werden, Teil-Datenpakete (220, 230, 240; 330, 340) generiert und an die Ausgabeeinheit (80, 180) ausgegeben werden und
• Teil-Datenpakete (220, 230, 240; 330, 340), die ihr von der Leseeinheit (70, 170) zugeführt werden, verarbeitet und in den Teil-Datenpaketen (220, 230, 240; 330, 340) enthaltene Befehle und/oder Daten adressierten Zielkomponenten (20, 30, 110) zugeführt werden.

3. Verfahren nach Anspruch 2, wobei die Ausgabeeinheit (80, 180) eine Startsequenz-Ausgabeeinheit (82, 182) und eine Codierungseinheit (84, 184) umfasst, das Teil-Datenpaket (220, 230, 240; 330, 340) in der Codierungseinheit (84, 184) codiert wird und das Datenpaket (200, 300) an den Datenübertragungskanal (50) ausgegeben wird, indem zuerst die Startsequenz-Ausgabeeinheit (82, 182) die Startsequenz (210, 310) und anschließend die Codierungseinheit (84, 184) das Teil-Datenpaket (220, 230, 240; 330, 340) ausgibt.

4. Verfahren nach Anspruch 2, wobei die Leseeinheit (70, 170) eine Vergleichereinheit (72, 172) und eine Decodierungseinheit (74, 174) umfasst, die Vergleichereinheit (72, 172) einen über den Datenübertragungskanal (50) eintreffenden Datenstrom mit der Startsequenz (210, 310) vergleicht und ein positives Vergleichsergebnis der Decodierungseinheit (74, 174) signalisiert und daraufhin von der Decodierungseinheit (74, 174) das Teil-Datenpaket (220, 230, 240; 330, 340) decodiert und der Kommunikationseinheit (90, 190) zuführt wird.

5. Verfahren nach Anspruch 4, wobei die Leseeinheit (70, 170) weiter eine Synchronisationseinheit (76, 176) umfasst, der der über den Datenübertragungskanal (50) eintreffende Datenstrom zugeführt wird und mit der der Datenstrom mit einem Arbeitstaktsignal (CLK, ACLK) synchronisiert wird.

6. Verfahren nach einem der vorhergehenden Ansprüche, wobei die Codierung eine Bitcodierung ist.

7. Verfahren nach Anspruch 6, wobei die Codierung eine Manchester-Codierung ist, bei der der Datenstrom zur Übertragung der Datenrahmen (200, 300) eine Abfolge von kurzen Symbolen (K) und langen Symbolen (L) aufweist und im Datenstrom bei regulärer Codierung stets eine gerade Anzahl von kurzen Symbolen (K) aufeinanderfolgt und die Leseeinheit (70, 170) weiter einen Symbolentscheider (78, 178) umfasst, dem von der Synchronisationseinheit (76, 176) der synchronisierte Datenstrom zugeführt wird und der die Abfolge von kurzen Symbolen (K) und langen Symbolen (L) im synchronen Datenstrom ermittelt und lediglich diese Information an die Decodierungseinheit (74, 174) zur Decodierung weiterleitet.

8. Verfahren nach Anspruch 7, wobei die Abweichung von der Codierung des übrigen Datenrahmens (220, 230, 240; 330, 340) darin besteht, dass in der Startsequenz (210, 310) wenigstens einmal ein einzelnes kurzes Symbol (K) oder eine ungerade Anzahl von aufeinanderfolgenden kurzen Symbolen (K) zwischen zwei langen Symbolen (L) auftritt.

9. Verfahren nach einem der Ansprüche 1 bis 5, wobei die Codierung eine Bitgruppencodierung ist und die Abweichung von der Codierung des übrigen Datenrahmens (220, 230, 240; 330, 340) darin besteht, dass die Startsequenz (210, 310) wenigstens eine Bitgruppe umfasst, die im übrigen Datenrahmen (220, 230, 240; 330, 340) nicht auftreten kann.

10. Vorrichtung zur seriellen Datenübertragung zwischen einer Positionsmesseinrichtung (10) und einer Folgeelektronik (100) über einen bidirektionalen Datenübertragungskanal (50), wobei in der Positionsmesseinrichtung (10) und in der Folgeelektronik (100) je eine Schnittstelleneinheit (40, 140) vorgesehen ist, in der aus zu sendenden Daten und/oder Befehlen, die ihr von Quellkomponenten (20, 30, 110) zuführbar sind, Datenrahmen (200, 300) erzeugbar, entsprechend einem Datenübertragungscode codierbar und an den Datenübertragungskanal ausgebbar sind, und wobei jeweils senderseitig die Datenübertragung mit einer Startsequenz (210, 310) einleitbar ist, deren Codierung von der Codierung des übrigen Datenrahmens (220, 230, 240; 330, 340) zumindest teilweise abweicht und jeweils empfängerseitig in der Schnittstelleneinheit (40, 140) der Beginn der Datenübertragung nach einer Umkehrung der Datenrichtung durch die Feststellung der Startsequenz (210, 310) erkennbar ist.

11. Vorrichtung nach Anspruch 10, wobei die Schnittstelleneinheit (40, 140) eine Kommunikationseinheit (90, 190), eine Ausgabeeinheit (80, 180) und eine Leseeinheit (70, 170) umfasst und wobei in der Kommunikationseinheit (90, 190)
• aus zu sendenden Daten und/oder Befehlen, die ihr von Quellkomponenten (20, 30, 110) zuführbar sind, Teil-Datenpakete (220, 230, 240; 330, 340) generierbar und an die Ausgabeeinheit (80, 180) ausgebbar sind und
• Teil-Datenpakete (220, 230, 240; 330, 340), die ihr von der Leseeinheit (70, 170) zuführbar sind, verarbeitbar und in den Teil-Datenpaketen (220, 230, 240; 330, 340) enthaltene Befehle und/oder Daten den adressierten Zielkomponenten (20, 30, 110) zuführbar sind.

12. Vorrichtung nach Anspruch 11, wobei die Ausgabeeinheit (80, 180) eine Startsequenz-Ausgabeeinheit (82, 182) und eine Codierungseinheit (84, 184) umfasst, das Teil-Datenpaket (220, 230, 240; 330, 340) in der Codierungseinheit (84, 184) codierbar ist und das Datenpaket (200, 300) an den Datenübertragungskanal (50) ausgebbar ist, indem zuerst die Startsequenz-Ausgabeeinheit (82, 182) die Startsequenz (210, 310) und anschließend die Codierungseinheit (84) das Teil-Datenpaket (220, 230, 240; 330, 340) ausgibt.

13. Vorrichtung nach Anspruch 11 oder 12, wobei die Leseeinheit (70, 170) eine Vergleichereinheit (72, 172) und eine Decodierungseinheit (74, 174) umfasst, von der Vergleichereinheit (72, 172) ein über den Datenübertragungskanal (50) eintreffender Datenstrom mit der Startsequenz (210, 310) vergleichbar und ein positives Vergleichsergebnis der Decodierungseinheit (74, 174) signalisierbar ist und von der Decodierungseinheit (74, 174) das Teil-Datenpaket (220, 230, 240; 330, 340) decodierbar und der Kommunikationseinheit (90, 190) zuführbar ist.

14. Vorrichtung nach Anspruch 13, wobei die Leseeinheit (70, 170) weiter eine Synchronisationseinheit (76, 176) umfasst, der der über den Datenübertragungskanal (50) eintreffende Datenstrom zugeführt ist und mit der der Datenstrom mit einem Arbeitstaktsignal (CLK, ACLK) synchronisierbar ist.

15. Vorrichtung nach Anspruch 14, wobei die Codierung eine Manchester-Codierung ist, bei der der Datenstrom zur Übertragung der Datenrahmen (200, 300) eine Abfolge von kurzen Symbolen (K) und langen Symbolen (L) aufweist und die Leseeinheit (70, 170) weiter einen Symbolentscheider (78, 178) umfasst, dem von der Synchronisationseinheit (76, 176) der synchronisierte Datenstrom zuführbar ist und mit dem die Abfolge von kurzen Symbolen (K) und langen Symbolen (L) im synchronen Datenstrom ermittelbar und lediglich diese Information an die Decodierungseinheit (74, 174) zur Decodierung weiterleitbar ist.
